# EUROPÄISCHE PATENTSCHRIFT

(11) **EP 2 588 766 B1**
(45) Veröffentlichungstag und Bekanntmachung des Hinweises auf die Patenterteilung: **11.05.2016**
(21) Anmeldenummer: 11730263.8
(22) Anmeldetag: 29.06.2011
(51) Int. Cl.: F16B 21/08, B60R 13/02, H01R 13/74

(54) **BEFESTIGUNGSEINRICHTUNG**
FASTENING DEVICE
DISPOSITIF DE FIXATION

(30) Priorität: 01.07.2010 DE 102010030806
(43) Veröffentlichungstag der Anmeldung: 08.05.2013
(73) Patentinhaber: Continental Teves AG & Co. oHG, 60488 Frankfurt (DE)
(72) Erfinder: GOLL, Manfred, 63695 Glauburg 2 (DE); HAVERKAMP, Martin, 60385 Frankfurt (DE)
(86) Internationale Anmeldenummer: PCT/EP2011/060894
(87) Internationale Veröffentlichungsnummer: WO 2012/001035

(56) Entgegenhaltungen:
- DE-A1-102005 003 293
- DE-A1-102006 027 751
- US-A- 5 706 559
- US-A1- 2009 133 449

## Beschreibung

Die Erfindung betrifft eine Befestigungseinrichtung gemäß Oberbegriff von Anspruch 1 sowie die Verwendung der Befestigungseinrichtung zur Befestigung einer Sensoranordnung in Kraftfahrzeugen.

Üblicherweise werden Module, wie beispielsweise Sensoranordnungen, in Kraftfahrzeugen mittels wenigstens einer Schraubverbindung montiert, damit eine präzise und spielfreie bzw. robuste Fixierung des Moduls gewährleistet ist. Dabei werden häufig automatische Schraubwerkzeuge für den entsprechenden Schraubvorgang benutzt. Dadurch kann dieser Schraubvorgang zwar in relativ kurzer Zeit durchgeführt werden, aber das das zu befestigende Modul wird dabei mechanischen Belastungen, wie Vibrationen oder Stößen, in Zuge dieses automatisierten Schraubvorgangs ausgesetzt. Dies kann beispielsweise für Sensorelemente das Risiko einer Beschädigung darstellen oder bedarf einer zusätzlichen Schutzvorsorge bei der Ausbildung des Moduls.

Aus der Patentliteratur ist folgender Stand der Technik bekannt:
US 2009/0133449 A1 offenbart einen rastbaren Sensor zum Einrasten in die Ausnehmung eines Gehäuses, wobei der Sensor einen Sensorkörper und Rastelemente aufweist, die an dem Sensorkörper angeordnet sind und sich in Richtung seiner Längsachse über eine Länge erstrecken. Die Rastelemente weisen Stufen auf, wobei zumindest zwei Stufen in Richtung der Längsachse voneinander beabstandet sind.

DE 10 2006 027 751 A1 offenbart ein Befestigungselement zur Befestigung und/oder zur Fixierung eines Bauteils an einer mit einer Öffnung versehenen Halterung. Die Befestigung weist zwei im Abstand voneinander angeordnete biegsame Raststifte auf, die jeweils in der Nähe ihrer freien Enden mit Rastnasen versehen sind, welche über entgegengesetzte Außenseiten der Raststifte überstehen und nach Ihrem Durchtritt durch die Öffnung der Halterung einen Rand der Öffnung hintergreifen. Der Gegenstand nach dieser Druckschrift sieht vor, dass die beiden Raststifte in Aussparungen eines Vorsprungs angeordnet sind.

US 5,706,559 offenbart ein Rastelement zum Verbinden zweier Federplattenteile, wobei das Rastelement zwei benachbarte Vorsprünge mit jeweils einer Rastnase aufweist. Die Länge der Rastnasen sind unterschiedlich lang, so dass die Rastnasen, die Federplattenteile auch dann halten, wenn sich die Federplattenteile zueinander verschieben.

DE 10 2005 003 293 A1 offenbart eine Befestigungsvorrichtung für Sensoren oder Aktoren mit einem oder mehreren Schnapp- oder Rasthaken. Diese sind mit einem tragenden Element des Sensors oder Aktors stoffschlüssig verbunden, wobei eine erste Raststufe im Bereich der Schnapp- oder Rasthaken zum einrasten in einen Halter oder eine Auflage geeignet sind, und wobei mindestens eine zweite Abschrägung oder eine zweite Schnapp- oder Raststufe im Bereich der Schnapp- oder Rasthaken vorgesehen sind. Diese weitere Abschrägung erzeugt aufgrund einer radialen elastischen Verformung des Schnapp- oder Rasthakens eine elastische Kraftkomponente in axialer Richtung auf den Sensor oder Aktor.

Die Erfindung hat sich die Aufgabe gestellt, eine Befestigungseinrichtung vorzuschlagen, welche einen einfachen und/oder störungsarmen und/oder zügigen Befestigungsvorgang ermöglicht, bei dem insbesondere eine relativ präzise und robuste Befestigung erreicht wird, ohne dass eine Schraubverbindung genutzt wird.

Diese Aufgabe wird erfindungsgemäß gelöst durch die Befestigungseinrichtung gemäß Anspruch 1.

Es ist bevorzugt, dass die Befestigungseinrichtung zumindest drei Positionierelemente und wenigstens drei Einrast-Federelemente aufweist. Hierdurch werden eine genauere Einpassung und eine größere Stabilität der Befestigung bzw. Verbindung erreicht.

Es ist zweckmäßig, dass die Befestigungseinrichtung mindestens drei Positionierelemente aufweist, welche jeweils im Wesentlichen zumindest teilweise formschlüssig zu zumindest einem Bereich eines inneren Rands der Ausnehmung ausgebildet sind und die bei Einführung in die Ausnehmung oder Durchführung durch die Ausnehmung die Befestigungseinrichtung relativ zur Ausnehmung positionieren, und mindestens drei Einrast-Federelemente aufweist, welche zumindest teilweise biegsam ausgebildet sind und außerdem so ausgebildet sind, dass sie zumindest teilweise in die Ausnehmung eingeführt oder durch diese Ausnehmung durchgeführt, mechanisch einrasten und die Befestigungseinrichtung relativ zur Ausnehmung fixieren.

Jedes Einrast-Federelement weist vorzugsweise zumindest einen Widerhaken auf, welcher insbesondere als Schnapphaken oder Rasthaken ausgebildet ist.

Die Befestigungseinrichtung ermöglicht insbesondere eine spielfreie Fixierung bezüglich aller drei Raumachsen bzw. aller Freiheitsgrade.

Unter dem inneren Rand der Ausnehmung wird bevorzugt ebenso bzw. zusätzlich oder alternativ die innere Mantelfläche der Ausnehmung verstanden.

Die Ausnehmung ist bevorzugt als durchgängige Öffnung in einer Wand bzw. in einem Blech ausgebildet oder alternativ vorzugsweise als Sackloch mit Hinterschnitt ausgebildet.

Die Positionierelemente sind zweckmäßigerweise steif bzw. starr ausgebildet.

Unter dem Begriff biegsam wird vorzugsweise der Begriff elastisch verstanden.

Es ist bevorzugt, dass die Ausnehmung einen im Wesentlichen kreisförmigen Rand aufweist. Alternativ vorzugsweise ist die Ausnehmung als Nut oder Langloch ausgebildet.

Es ist bevorzugt, dass bezüglich eines Umfangs entlang des inneren Rands der Ausnehmung die Einrast-Federelemente abwechselnd mit den Positionierelementen angeordnet sind und insbesondere der jeweilige Winkelversatz zwischen den Einrast-Federelementen und den Positionierelementen im Wesentlichen gleich groß ausgebildet ist.

Bezogen auf eine bevorzugte Befestigungsrichtung, welche im Wesentlichen senkrecht zur Ausnehmungsgrundfläche und/oder zur Außenfläche des Körpers, in welche die Ausnehmung eingearbeitet ist, angeordnet ist, sind die Einrast-Federelemente vorzugsweise im unausgelenkten Zustand schräg oder zumindest nicht parallel ausgerichtet ausgebildet.

Unter einem unausgelenkten Zustand eines Federelements wird bevorzugt ein Zustand verstanden, in welchem keine Kraft und insbesondere kein Moment auf dieses Federelement einwirken, so dass keine Verformung des Federelements vorhanden ist.

Die Befestigungseinrichtung weist bevorzugt jeweils im Bereich der Einrast-Federelemente eine Schlüssel-Ausnehmung auf, die im Wesentlichen gerade ausgebildet ist, wobei in diese Schlüssel-Ausnehmung selbst oder in einen sich daran anschließenden Bereich, in Richtung dieser Schlüssel-Ausnehmung, das jeweilige Einrast-Federelement zumindest im unausgelenkten Zustand hineinragt. Insbesondere ist die Befestigungseinrichtung so ausgebildet, dass ein Schlüsselelement, was in eine dieser Schlüssel-Ausnehmungen eingeführt werden kann und/oder durchgeführt werden kann, das jeweilig dieser Schlüssel-Ausnehmung zugeordnete Einrast-Federelement so auslenkt, dass die Rastung bzw. die Befestigung bzw. Fixierung dieses Einrast-Federelements, bzw. die mit diesem Einrast-Federelement erreicht wird, gelöst wird, besonders bevorzugt um die Befestigungseinrichtung zu lösen, oder in einen nicht rastenden Zustand gebracht wird, besonders bevorzugt um die Befestigungseinrichtung besonders einfach zu montieren. Die Auslenkung des entsprechenden Einrast-Federelements wird dabei ganz besonders bevorzugt dadurch erreicht, dass das Schlüsselelement in der Schlüssel-Ausnehmung mechanisch abgestützt ist und das Einrast-Federelement an einer Oberfläche bzw. einer Schlüsselabstützfläche, schräg zum geraden Verlauf der Schlüssel-Ausnehmung, berührt und so eine Kraft auf das Einrast-Federelement zu dessen Auslenkung ausübt.

Die Schlüsselabstützfläche ist zweckmäßigerweise Teil des Einrast-Federelements und so ausgebildet und angeordnet, dass die Flächennormale dieser Schlüsselabstützfläche im unausgelenkten Zustand des Einrast-Federelements nicht senkrecht zur Befestigungsrichtung ausgerichtet ist.

Es ist zweckmäßig, dass die Befestigungseinrichtung mindestens ein zusätzliches Abstütz-Federelement aufweist, welches so ausgebildet und angeordnet ist, dass es die Befestigungseinrichtung am Rand bzw. im Bereich des Rands der Ausnehmung und/oder an der Begrenzung der Ausnehmung abstützt. Hierdurch wird eine noch präzisere Positionierung der Befestigungseinrichtung in Befestigungsrichtung ermöglicht. Das mindestens eine Abstütz-Federelement ist dabei insbesondere zumindest teilweise biegsam ausgebildet und weist besonders bevorzugt eine Abstützfläche auf, die so ausgebildet und angeordnet ist, dass deren Flächennormale nicht parallel zur Befestigungsrichtung ausgerichtet ist. Alternativ vorzugsweise ist die Abstützfläche so ausgebildet und angeordnet, dass deren Flächennormale im Wesentlichen parallel zur Befestigungsrichtung ausgerichtet ist.

Die Befestigungseinrichtung ist vorzugsweise als Teil eines Gehäuses ausgebildet.

Es ist bevorzugt, dass die Befestigungseinrichtung aus Kunststoff und/oder zumindest teilweise aus Metall ausgebildet ist.

Zweckmäßigerweise sind die Einrast-Federelemente und/oder die Positionierelemente und/oder die Abstütz-Federelemente aus Metall ausgebildet und insbesondere mit einem Metallrahmen verbunden, welcher, besonders bevorzugt mittels Spritzgießens, in ein Kunststoffgehäuse integriert bzw. eingebettet ist. Um diesen Metallrahmen leichter Umspritzen zu können weist diese ganz besonders bevorzugt zumindest ein Loch auf.

Die Erfindung bezieht sich außerdem auf die Verwendung der Befestigungseinrichtung zur Befestigung einer Sensoranordnung in Kraftfahrzeugen.

Weitere bevorzugte Ausführungsformen ergeben sich aus den Unteransprüchen und der nachfolgenden Beschreibung von Ausführungsbeispielen an Hand von Figuren.

Es zeigen in schematischer Darstellung
- Fig. 1: eine beispielhafte Befestigungseinrichtung mit vier Positionierelementen und vier Einrast-Federelementen,
- Fig. 2: eine beispielhafte Veranschaulichung eines Befes-tigungsvorgangs mit der Befestigungseinrichtung ans Fig. 1,
- Fig. 3: ein Ausführungsbeispiel einer Befestigungseinrich-tung mit zusätzlichen Abstütz-Federelementen,
- Fig. 4: ein Ausführungsbeispiel mit jeweils drei Positio-nierelementen, Einrast-Federelementen und Abstütz-Federelementen,
- Fig. 5: ein alternatives Ausführungsbeispiel der Befesti-gungseinrichtung zur Integration in ein Gehäuse,
- Fig. 6: ein beispielhaft veranschaulichter Löse- bzw. Ent-rastvorgang mittels eines Schlüsselelements, sowie
- Fig. 7: eine beispielhafte Integration der Befestigungs-einrichtung in ein Gehäuse.

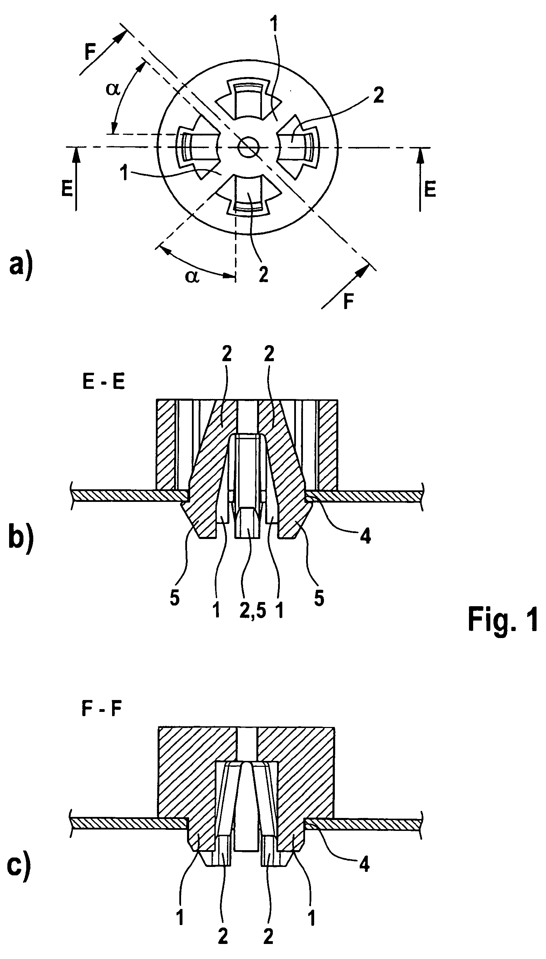

Fig. 1 a) zeigt eine beispielhafte Befestigungseinrichtung aus der Draufsicht mit vier Positionierelementen 1 und vier Einrast-Federelementen 2, welche jeweils zueinander den gleichen Winkelversatz α aufweisen. Fig. 1 b) zeigt diese Befestigungseinrichtung in einem Schnitt E-E und Fig. 1 c) in einer Schnittebene durch die Schnittgerade F-F. Dabei ist die Positioniereinrichtung jeweils in einer Ausnehmung positioniert und fixiert. Positionierelemente 4 berühren den inneren Rand 4 der Ausnehmung und die Widerhaken 5 der Einrast-Federelemente 2 sind in der Ausnehmung eingerastet bzw. umgreifen den inneren Rand der Ausnehmung teilweise.

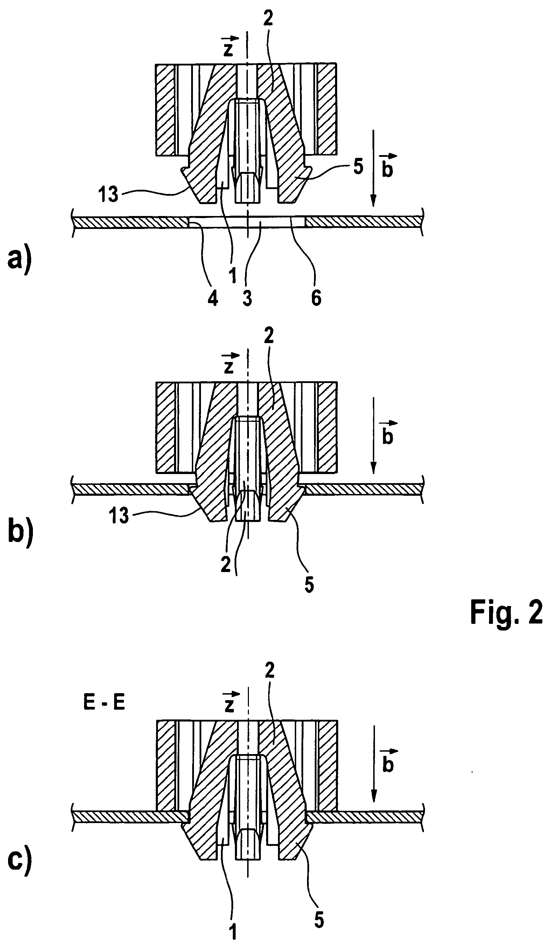

Anhand der Fig. 2 a), b) und c) ist das Positionieren und Fixieren der Befestigungseinrichtung aus Fig. 1 in einer Ausnehmung 3 veranschaulicht. Die Befestigungseinrichtung wird in bzw. entlang der Befestigungsrichtung *̅b̅*̅ in Ausnehmung 4 eingeführt, dabei darin mittels der Positionierelemente 1 positioniert und mittels der Einrast-Federelemente 2 mit deren Widerhaken 5 fixiert. Wie in Fig. 2 a) dargestellt, sind die Einrast-Federelemente 2 im unausgelenkten Zustand schräg bzw. nicht parallel zur Befestigungsrichtung *̅b̅*̅ ausgerichtet, welche senkrecht zur Ausnehmungsgrundfläche 6 ausgerichtet ist, die hier von der Seite schematisch dargestellt ist. Während des Einführungsvorgangs der Befestigungsrichtung in die Ausnehmung sind die Einrast-Federelemente 2 mit Widerhaken 5 zurückgebogen bzw. zu einer zentralen Achse *̅z̅*̅ der Befestigungseinrichtung, parallel zur Befestigungsrichtung *̅b̅*̅, hingebogen. Dafür weisen die Widerhaken 5 jeweils eine schräge Einpassstirnfläche 13, auf welche der Rand der Ausnehmung beim Einfügen bzw. Einpassen eine Kraft ausübt und die Widerhaken zurückbiegt, so dass sie in die Ausnehmung eingeführt werden können. In Fig. 2 c) ist die Befestigungseinrichtung positioniert und fixiert. Die Widerhaken 5 sind dabei eingerastet.

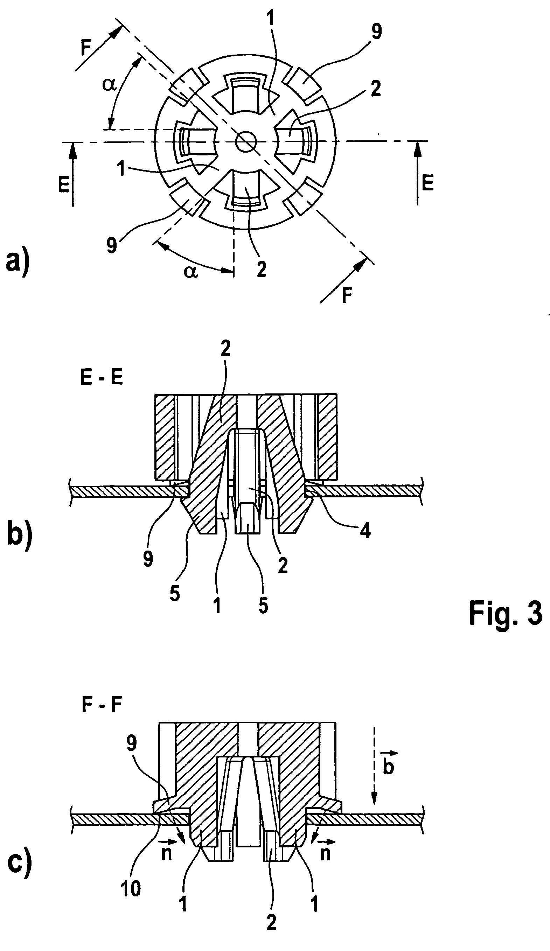

In Fig. 3a), b) und c) ist ein alternatives Ausführungsbeispiel der Befestigungseinrichtung dargestellt, welches zusätzlich zu den vier Positionierelementen 1 und den vier Einrast-Federelementen 2 vier Abstütz-Federelemente 9 aufweist. Fig. 3 a) zeigt dabei die Draufsicht auf die Befestigungseinrichtung und Fig. 3 b) und c) Schnitte in Seitenansicht bezüglich der Schnittgeraden E-E bzw. F-F. Einrast-Federelemente 2 weisen jeweils einen Widerhaken 5 auf mit welchem sie beispielhaft am inneren Rand der Ausnehmung 4 eingehakt bzw. eingerastet sind. Abstütz-Federelemente 9 sind so ausgebildet und angeordnet, dass sie die Befestigungseinrichtung am Rand bzw. im Bereich des Randes der Ausnehmung abstützen, und zwar an der Außenfläche des Körpers, in die Ausnehmung eingelassen ist und von der aus die Befestigungseinrichtung montiert wird. Die Abstütz-Federelemente 9 sind biegsam ausgebildet und sind im unausgelenkten Zustand so ausgebildet und angeordnet, dass die Flächennormale *̅n̅*̅ ihrer jeweiligen Abstützfläche 10 nicht parallel zur Befestigungsrichtung *̅b̅*̅ ausgerichtet ist, wodurch eine Federkraft auch im montierten Zustand der Befestigungseinrichtung zentrierend und bezüglich der Positionierung präzisierend wirkt.

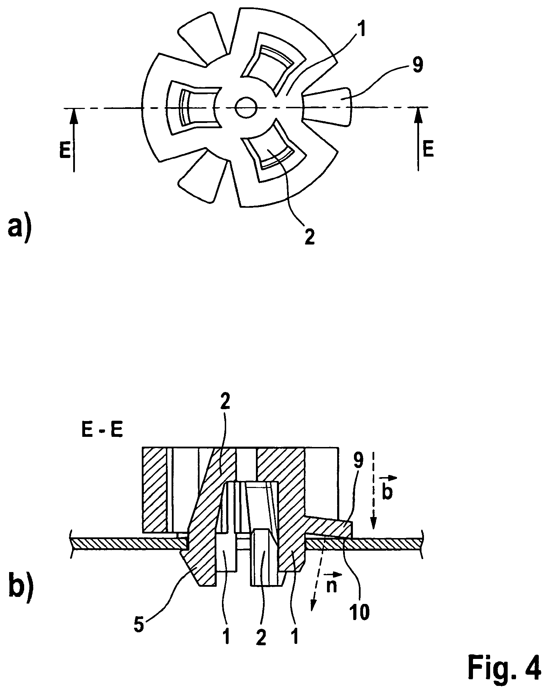

Fig. 4 a) und b) zeigen eine alternative Befestigungseinrichtung mit drei Positionierelementen 1, drei Einrast-Federelementen 2 mit Widerhaken 5 und drei Abstütz-Federelementen 9. Wobei diese Abstütz-Federelemente 9 ebenfalls biegsam ausgebildet sind und im unausgelenkten Zustand so ausgebildet und angeordnet sind, dass die Flächennormale *̅n̅*̅ ihrer jeweiligen Abstützfläche 10 nicht parallel zur Befestigungsrichtung *̅b̅*̅ ausgerichtet ist.

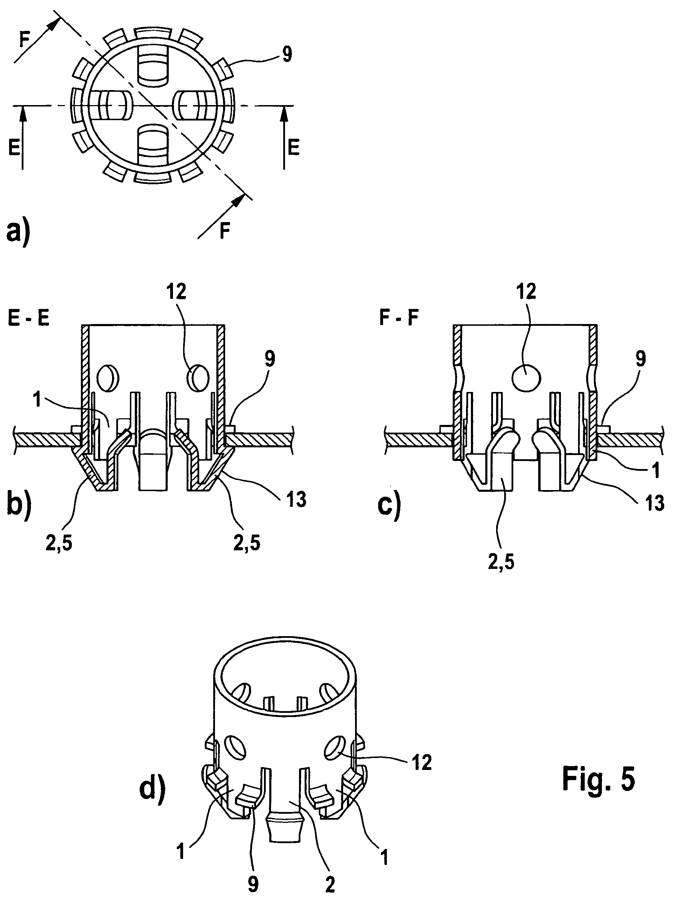

In Fig. 5 a) bis d) ist eine Befestigungseinrichtung in verschiedenen Ansichten dargestellt, die zur Integration in ein Kunststoffgehäuse mittels Spitzguss ausgebildet ist. Dazu weist der im Wesentlichen hohlzylinderförmigen Rahmen der Befestigungseinrichtung ein Loch 12 auf, das den Umspritzvorgang erleichtert. Diese Befestigungseinrichtung umfasst vier Positionierelemente 1, vier Einrast-Federelemente 2, jeweils mit einem Widerhaken 5 und einer Einpassstirnfläche 13, sowie 8 Abstütz-Federelementen 9, deren Abstützfläche jeweils parallel zur Ausnehmungsgrundfläche ausgebildet ist.

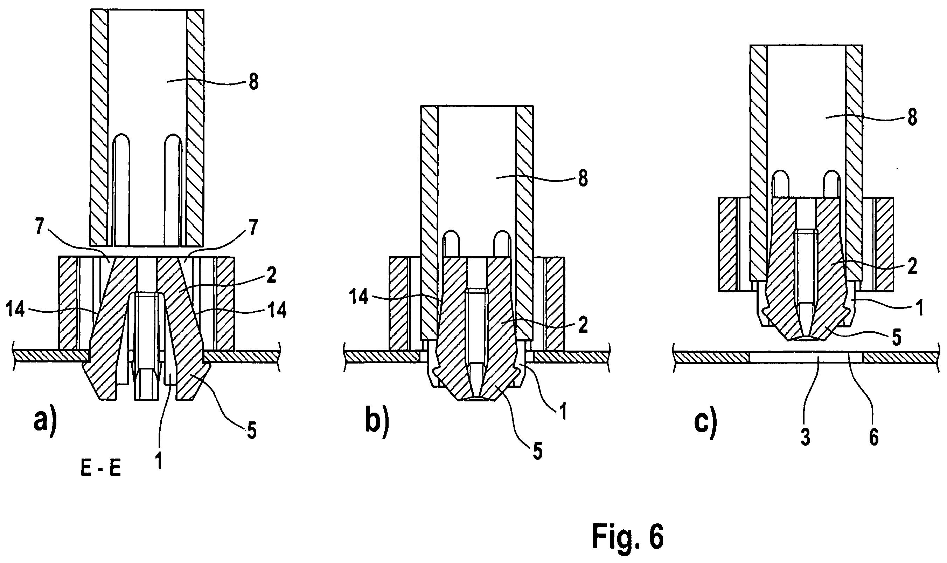

Anhand der Fig. 6 a), b) und c) ist ein Lösevorgang der Befestigungseinrichtung mittels eines Schlüsselelements 8 beispielhaft veranschaulicht. Die Befestigungseinrichtung weist hierfür im Bereich der Einrast-Federelemente 2, 5 jeweils eine Schlüssel-Ausnehmung 7 auf, die im Wesentlichen gerade, also nicht gebogen, ausgebildet ist, wobei in diese Schlüssel-Ausnehmung 7 das jeweilige Einrast-Federelement 2 hineinragt. Die Auslenkung des entsprechenden Einrast-Federelements 2 wird dadurch erreicht, dass das Schlüsselelement 8 in die Schlüssel-Ausnehmung 7 eingeführt wird und in dieser mechanisch abgestützt ist und das Einrast-Federelement 2 an einer Schlüsselabstützfläche 14, schräg zum geraden Verlauf der Schlüssel-Ausnehmung 7, berührt und so eine Kraft auf das Einrast-Federelement 2 zu dessen Auslenkung ausübt. In Fig. 6 a) ist die Befestigungseinrichtung fixiert und die Widerhaken 5 sind eingerastet. In Fig. 6 b) ist das Schlüsselelement 8 in die Schlüssel-Ausnehmungen 7 eingeführt und hat über die Schlüsselabstützflächen 14 die Einrast-Federelemente 2 ausgelenkt und in einen nichtverrasteten Zustand gebracht. Danach wird wie in Fig. 6 c) veranschaulicht die Befestigungseinrichtung in diesem Zustand mit noch steckendem Schlüsselelement 8 aus der Ausnehmung 3 gelöst bzw. entnommen. In einem nicht veranschaulichten Alternativbeispiel ist der umgekehrte Vorgang als Montage- bzw. Befestigungsvorgang durchführbar.

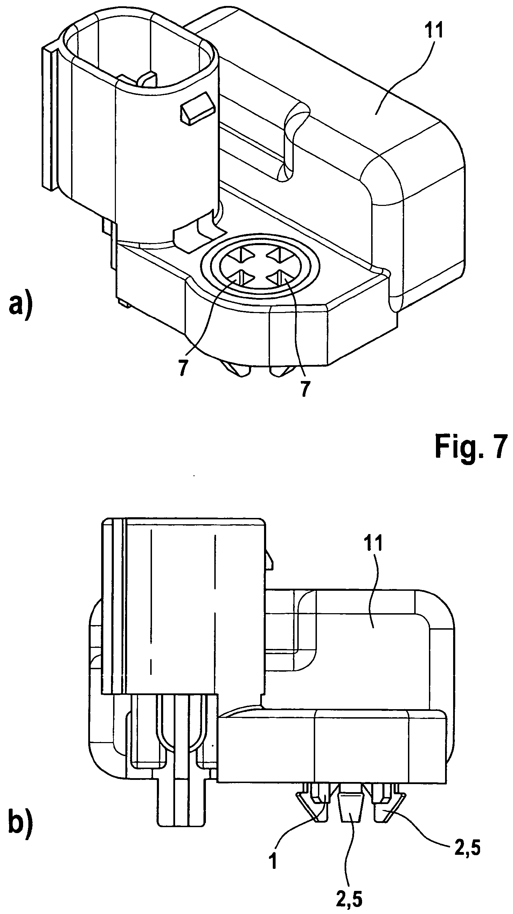

Fig. 7 a) und b) zeigt eine Befestigungseinrichtung mit Positionierelementen 1 und Einrast-Federelementen 2, 5, aus unterschiedlichen Perspektiven, die als Teil eines Gehäuses 11 ausgebildet ist.

### Bezugszeichenliste

- 1: Positionierelement
- 2: Einrast-Federelement
- 3: Ausnehmung
- 4: Innerer Rand der Ausnehmung
- 5: Widerhaken des Einrast-Federelements
- 6: Ausnehmungsgrundfläche
- 7: Schlüssel-Ausnehmung
- 8: Schlüsselelement
- 9: Abstütz-Federelement
- 10: Abstützfläche des Abstütz-Federelements
- 11: Gehäuse
- 12: Loch im Rahmen der Befestigungseinrichtung
- 13: Einpassstirnfläche des Widerhakens
- 14: Schlüsselabstützfläche des Einrast-Federelements
- α: Winkelversatz zwischen Einrast-Federelement und Positionierelement
- *̅b̅*̅: Befestigungsrichtung der Befestigungseinrichtung
- *̅n̅*̅: Flächennormale der Abstützfläche des Abstütz-Federelements
- *̅z̅*̅: Zentrale Achse der Befestigungseinrichtung

## Patentansprüche

1. Befestigungseinrichtung zur Positionierung und/oder Fixierung in einer Ausnehmung (3, 4),
wobei
die Befestigungseinrichtung mindestens ein Positionierelement (1) aufweist, welches im Wesentlichen zumindest teilweise formschlüssig zu zumindest einem Bereich eines inneren Rands (4) der Ausnehmung ausgebildet ist und welches bei Einführung in die Ausnehmung (3, 4) oder Durchführung durch die Ausnehmung (3, 4) die Befestigungseinrichtung relativ zur Ausnehmung positioniert, und mindestens ein Einrast-Federelement (2) aufweist, welches zumindest teilweise biegsam ausgebildet ist und außerdem so ausgebildet ist, dass es zumindest teilweise in die Ausnehmung (3, 4) eingeführt oder durch diese Ausnehmung durchgeführt, mechanisch einrastet und die Befestigungseinrichtung relativ zur Ausnehmung (3, 4) fixiert.

2. Befestigungseinrichtung nach Anspruch 1, **dadurch gekennzeichnet, dass** die Befestigungseinrichtung zumindest drei Positionierelemente (1) und wenigstens drei Einrast-Federelemente (2) aufweist.

3. Befestigungseinrichtung nach Anspruch 1 oder 2, **dadurch gekennzeichnet, dass** jedes Einrast-Federelement (2) zumindest einen Widerhaken (5) aufweist, welcher insbesondere als Schnapphaken oder Rasthaken ausgebildet ist.

4. Befestigungseinrichtung nach mindestens einem der Ansprüche 1 bis 3, **dadurch gekennzeichnet, dass** bezüglich eines Umfangs entlang des inneren Rands (4) der Ausnehmung die Einrast-Federelemente (2, 5) abwechselnd mit den Positionierelementen (1) angeordnet sind und insbesondere der jeweilige Winkelversatz (α) zwischen den Einrast-Federelementen (2, 5) und den Positionierelementen (1) im Wesentlichen gleich groß ausgebildet ist.

5. Befestigungseinrichtung nach mindestens einem der Ansprüche 1 bis 4, **dadurch gekennzeichnet, dass** bezogen auf eine Befestigungsrichtung (*̅b̅*̅), welche im Wesentlichen senkrecht zur Ausnehmungsgrundfläche (6) und/oder zur Außenfläche des Körpers, in welche die Ausnehmung (3) eingearbeitet ist, angeordnet ist, die Einrast-Federelemente (2) im unausgelenkten Zustand schräg oder zumindest nicht parallel ausgerichtet ausgebildet sind.

6. Befestigungseinrichtung nach mindestens einem der Ansprüche 1 bis 5, **dadurch gekennzeichnet, dass** diese jeweils im Bereich der Einrast-Federelemente (2) eine Schlüssel-Ausnehmung (7) aufweist, die im Wesentlichen gerade ausgebildet ist, wobei in diese Schlüssel-Ausnehmung (7) selbst oder in einen sich daran anschließenden Bereich, in Richtung dieser Schlüssel-Ausnehmung, das jeweilige Einrast-Federelement (2) zumindest im unausgelenkten Zustand hineinragt.

7. Befestigungseinrichtung nach Anspruch 6, **dadurch gekennzeichnet, dass** diese so ausgebildet ist, dass ein Schlüsselelement (8), was in eine dieser Schlüssel-Ausnehmungen (7) eingeführt werden kann und/oder durchgeführt werden kann, das jeweilig dieser Schlüssel-Ausnehmung (7) zugeordnete Einrast-Federelement (2) so auslenken kann, dass die Rastung dieses Einrast-Federelements gelöst wird oder in einen nicht rastenden Zustand gebracht wird.

8. Befestigungseinrichtung nach mindestens einem der Ansprüche 1 bis 7, **dadurch gekennzeichnet, dass** diese Befestigungseinrichtung mindestens ein zusätzliches Abstütz-Federelement (9) aufweist, welches so ausgebildet und angeordnet ist, dass es die Befestigungseinrichtung am Rand (4) und/oder an der Begrenzung der Ausnehmung (3) abstützt.

9. Befestigungseinrichtung nach Anspruch 8, **dadurch gekennzeichnet, dass** das mindestens eine Abstütz-Federelement (9) zumindest teilweise biegsam ausgebildet ist und insbesondere eine Abstützfläche (10) aufweist, die so ausgebildet und angeordnet ist, dass deren Flächennormale (*̅n̅*̅) nicht parallel zur Befestigungsrichtung (*̅b̅*̅) ausgerichtet ist.

10. Befestigungseinrichtung nach mindestens einem der Ansprüche 1 bis 9, **dadurch gekennzeichnet, dass** diese Befestigungseinrichtung als Teil eines Gehäuses (11) ausgebildet ist.

11. Verwendung der Befestigungseinrichtung nach mindestens einem der Ansprüche 1 bis 10 zur Befestigung einer Sensoranordnung in Kraftfahrzeugen.

## Claims

1. Fastening device for positioning and/or fixing in a recess (3, 4), wherein the fastening device has at least one positioning element (1) which is substantially formed at least partially in an interlocking manner with at least one region of an inner edge (4) of the recess and which, upon insertion into the recess (3, 4) or leading through the recess (3, 4), positions the fastening device relative to the recess and has at least one latching spring element (2) which is at least partially of flexible design and also is designed in such a manner that it is at least partially inserted into the recess (3, 4) or guided through said recess, snaps in place mechanically and fixes the fastening device relative to the recess (3, 4).

2. Fastening device according to Claim 1, **characterized in that** the fastening device has at least three positioning elements (1) and at least three latching spring elements (2).

3. Fastening device according to Claim 1 or 2, **characterized in that** each latching spring element (2) has at least one barb (5) which is designed in particular as a snap hook or latching hook.

4. Fastening device according to at least one of Claims 1 to 3, **characterized in that** the latching spring elements (2, 5) are arranged in an alternating manner with the positioning elements (1) with respect to a circumference along the inner edge (4) of the recess, and in particular the respective angular offset (α) between the latching spring elements (2, 5) and the positioning elements (1) is of substantially identical size.

5. Fastening device according to at least one of Claims 1 to 4, **characterized in that** the latching spring elements (2) in the undeflected state are formed obliquely, or at least are not aligned in parallel, with respect to a fastening direction (*̅b̅*̅) which is arranged substantially perpendicularly to the recess area (6) and/or to the outer surface of the body, in which outer surface the recess (3) is incorporated.

6. Fastening device according to at least one of Claims 1 to 5, **characterized in that** said fastening device has, in each case in the region of the latching spring elements (2), a key recess (7) which is of substantially rectilinear design, wherein the respective latching spring element (2) projects, at least in the undeflected state, in the direction of said key recess, into said key recess (7) itself or into an adjoining region.

7. Fastening device according to Claim 6, **characterized in that** said fastening device is designed in such a manner that a key element (8) which can be inserted into one of said key recesses (7) and/or can be guided therethrough, can deflect the respective latching spring element (2), which is assigned to said key recess (7), in such a manner that the latching of said latching spring element is released or is brought into a non-latching state.

8. Fastening device according to at least one of Claims 1 to 7, **characterized in that** said fastening device has at least one additional supporting spring element (9) which is designed and arranged in such a manner that it supports the fastening device on the edge (4) and/or on the boundary of the recess (3).

9. Fastening device according to Claim 8, **characterized in that** the at least one supporting spring element (9) is at least partially of flexible design and in particular has a supporting surface (10) which is designed and arranged in such a manner that the surface normal (*̅n̅*̅) thereof is not oriented parallel to the fastening direction (*̅b̅*̅).

10. Fastening device according to at least one of Claims 1 to 9, **characterized in that** said fastening device is formed as part of a housing (11).

11. Use of the fastening device according to at least one of Claims 1 to 10 for fastening a sensor arrangement in motor vehicles.

## Revendications

1. Dispositif de fixation à positionner et/ou à fixer dans un évidement (3, 4),
dans lequel le dispositif de fixation comporte au moins un élément de positionnement (1) qui est conçu sensiblement au moins en partie à complémentarité de forme avec au moins une zone d'un bord intérieur (4) de l'évidement et qui, lors de l'introduction dans l'évidement (3, 4) ou du guidage à travers l'évidement (3, 4), positionne le dispositif de fixation par rapport à l'évidement, et comporte au moins un élément à ressort d'encliquetage (2) qui est conçu au moins en partie de manière à être flexible et est en outre conçu de manière à s'encliqueter mécaniquement lorsqu'il est introduit au moins en partie dans l'évidement (3, 4) et à fixer le dispositif de fixation par rapport à l'évidement (3, 4).

2. Dispositif de fixation selon la revendication 1, **caractérisé en ce que** le dispositif de fixation comporte au moins trois éléments de positionnement (1) et au moins trois éléments à ressort d'encliquetage (2).

3. Dispositif de fixation selon la revendication 1 ou 2, **caractérisé en ce que** chaque élément à ressort d'encliquetage (2) comporte au moins un picot (5) qui est notamment réalisé sous la forme d'un mousqueton ou d'un crochet d'encliquetage.

4. Dispositif de fixation selon au moins l'une des revendications 1 à 3, **caractérisé en ce que** les éléments à ressort d'encliquetage (2, 5) sont disposés de manière alternée avec les éléments de positionnement (1) par rapport à une périphérie le long du bord intérieur (4) de l'évidement et en particulier, **en ce que** les décalages angulaires (α) respectifs entre les éléments à ressort d'encliquetage (2, 5) et les éléments de positionnement (1) sont formés de manière à être sensiblement identiques.

5. Dispositif de fixation selon au moins l'une des revendications 1 à 4, **caractérisé en ce que**, par rapport à la direction de fixation (*̅b̅*̅), qui est disposé sensiblement perpendiculairement à la surface de base (6) de l'évidement et/ou à la surface extérieure du corps dans lequel l'évidement (3) est ménagé, les éléments à ressort d'encliquetage (2) sont formés de manière inclinée dans un état non écarté ou de manière orientée au moins non parallèlement.

6. Dispositif de fixation selon au moins l'une des revendications 1 à 5, **caractérisé en ce qu'**il comporte, dans la région des éléments à ressort d'encliquetage (2), un évidement de clé (7) qui est formé de manière sensiblement rectiligne, dans lequel l'élément à ressort d'encliquetage (2) s'encliquète dans l'état non écarté dans ledit évidement de clé (7) lui-même ou dans une zone contiguë à celui-ci, dans la direction dudit évidement de clé.

7. Dispositif de fixation selon la revendication 6, **caractérisé en ce qu'**il est réalisé de manière à ce qu'un élément de clé (8), qui peut être inséré dans l'un desdits évidements de clé (7) et/ou qui peut être amené à passer à travers ceux-ci, peut écarter l'élément à ressort d'encliquetage (2) respectivement associé audit évidement de clé (7) de manière à ce que l'encliquetage dudit élément à ressort d'encliquetage puisse être dégagé ou soit amené à passer à un état non encliqueté.

8. Dispositif de fixation selon au moins l'une des revendications 1 à 7, **caractérisé en ce que** ledit dispositif de fixation comporte au moins un élément à ressort de support (9) supplémentaire qui est réalisé et disposé de manière à ce qu'il supporte le dispositif de fixation sur le bord (4) et/ou au niveau de la limite de l'évidement (3).

9. Dispositif de fixation selon la revendication 8, **caractérisé en ce que** l'au moins un élément à ressort de support (9) est formé au moins en partie de manière flexible et comporte notamment une surface de support (10) qui est réalisée et disposée de manière à ce que la normale à sa surface (*̅n̅*̅) ne soit pas orientée parallèlement au dispositif de fixation (*̅b̅*̅).

10. Dispositif de fixation selon au moins l'une des revendications 1 à 9, **caractérisé en ce que** ledit dispositif de fixation est réalisé en tant que partie d'un boîtier (11).

11. Utilisation du dispositif de fixation selon au moins l'une des revendications 1 à 10, pour fixer un système de capteur dans des véhicules automobiles.
